# EUROPEAN PATENT APPLICATION

(11) **EP 4 835 960 A1**
(43) Date of publication of application: **04.11.2026**
(21) Application number: 25173677.3
(22) Date of filing: 30.04.2025
(51) Int. Cl.: H01L 23/498

(54) **BALL GRID ARRAY**

(71) Applicant: NXP USA, Inc., Austin, TX 78735 (US)
(72) Inventor: LEE, Chu-Chung, Austin 78735 (US); LIU, Haiyan, Tianjin 300385 (CN); DE WITTE, Jetse, Austin 78735 (US); TRAN, Tu-Anh Ngoc, Austin 78735 (US); SAMSOL BAHRI, Hazika Hannah Binti, 47300 Kuala Lumpur (MY); FAHIM, Abdullah, Austin 78735 (US); LIM, Swee Yean, 47300 Petaling Jaya (MY); MAVINKURVE, Amar Ashok, 6534 AE Nijmegen (NL); KISHORE, Sharan, Chandler 85224 (US); CHEN, Yaxiong, Austin 78735 (US); AU, Yin Kheng, 47300 Kuala Lumpur (MY); ZHANG, Xinyu, Tianjin 300385 (CN)
(74) Representative: Schwarzweller, Thomas

(57) **Abstract**

There is provided a semiconductor device having a Ball Grid Array, BGA. The BGA has a die attach material having a first coefficient of thermal expansion and a solder mask material having a second coefficient of thermal expansion. A difference between the first and second coefficients of thermal expansion multiplied by a Young's modulus of the die attach material is below 100 GPa/°C.

## Description

### FIELD

The present disclosure relates to semiconductor device having a Ball Grid Array, BGA. In particular, the present disclosure relates to a mechanical property range for die attach and solder mask materials used in a BGA.

### BACKGROUND

Ball grid arrays, BGA, including MAPBGA (Mold Array Process BGA) are a type of surface-mount packaging used in integrated circuits that uses a grid of solder balls for electrical connections. In automotive applications such as electric vehicles BGA packages are required to withstand certain conditions.

BGA and MAPBGA packaging are being investigated for use in traction converters in electric vehicles. Stress fractures can cause problems in MAPBGA when used in such automotive applications where high performance demands exceed those of other MAPBGA applications. One commonly found stress failure during Temperature Cycling (TC) stress testing is an M1 Cu or other metal such as Sn or solder alloys trace crack where the trace of the MAPBGA is damaged during prolonged TC stresses. M1 Cu is a chemical composition typically used in BGA and MAPBGA. The Automotive Electronics Council (AEC) Q006 specification requires devices to be able to pass stress temperature cycling testing at 2000 cycles (TC2000) for AEC G1 and to pass temperature cycling at 3000 cycles (TC3000) for AEC G0 tiers. AEC G1 and G0 tiers are defined based on their application. G0 has higher application temperatures leading to more severe working conditions. Thus, G0 requires higher numbers of TC to meet a "mission profile" with survival time more than 10 or 15 years.

Therefore, there is a need to develop a new BGA material set to meet the new automotive requirements and prevent stress failure.

### SUMMARY

According to a first aspect, there is provided a semiconductor device having a Ball Grid Array, BGA. The semiconductor device having a substrate comprising a solder mask material. The substrate having an upper surface and a lower surface. The semiconductor device further comprising a die and a die attach material for affixing the die to the upper surface of the substrate. The lower surface of the substrate comprising a plurality of solder balls arranged in a ball grid array.

The semiconductor device comprising a die attach material, the die attach material having a first coefficient of thermal expansion; and a solder mask material, the solder mask material having a second coefficient of thermal expansion. A difference between the first and second coefficients of thermal expansion multiplied by a Young's modulus of the die attach material is ≤ 100 GPa/°C.

Optionally, wherein the solder mask material is provided on the upper surface of the substrate to form an interface with the die attach material.

Optionally, wherein the solder mask material is provided on the lower surface of the substrate to form an interface with the plurality of solder balls.

In some embodiments, the solder mask material is provided on the upper and lower surfaces of the substrate. In some embodiments, the solder mask material on the upper surface and the lower surface of the substrate is a same material. In other embodiments, the solder mask material on the upper surface of the substrate is a different material to the solder mask material on the lower surface of the substrate.

In some embodiments, a fracture toughness of the solder mask material is ≥ 0.10 MPa. This value should be exhibited for the solder mask material both as received and after ageing of the solder mask material (such as by temperature cycling for TC2000).

In some embodiments, a fracture toughness of the solder mask material is < 0.10 MPa and ≥ 0.07 MPa. This value should be exhibited for the solder mask material both as received and after ageing of the solder mask material (such as by temperature cycling for TC2000).

In some embodiments, the difference between the first and second coefficients of thermal expansion multiplied by a Young's modulus of the die attach material is ≤ 60 GPa/°C.

In some embodiments, a toughness of the solder mask material is ≥ 2.0 MPa.m^{0.5}. Optionally, a toughness of the solder mask material is ≥ 2.3 MPa.m^{0.5}. This value should be exhibited for the solder mask material both as received and after ageing of the solder mask material (such as by temperature cycling for TC2000).

In some embodiments, a shear adhesion strength range between the die attach and solder mask materials is ≥ 4 MPa.

In some embodiments, a bond line thickness of the die attach material is ≤ 50 µm. Optionally, the bond line thickness of the die attach material is ≥ 25 µm.

In some embodiments, the BGA comprises a substrate having a via plug that is a different material to the solder mask material. Optionally, wherein a Young's modulus of the via plug material is between 5 and 9 GPa. The Young's modulus range of the material is measured between -40 °C and 25 °C (room temperature).

Optionally, wherein the via plug material has a first coefficient of thermal expansion of between 25 to 45 ppm/°C below a glass transition temperature. Optionally, wherein the via plug material has a second coefficient of thermal expansion between 90 and 120 ppm/°C above the glass transition temperature. Optionally, wherein the via plug material has a water absorption rate of ≤ 0.3%.

In some embodiments, the BGA is a Mold Array Process Ball Grid Array, MAPBGA.

### BRIEF DESCRIPTION OF DRAWINGS

A more complete understanding of the subject matter may be derived by referring to the detailed description and claims when considered in conjunction with the following figures, wherein like reference numbers refer to similar elements throughout the figures.
Figure 1A illustrates a cross-section of a MAPBGA according to an embodiment of the present disclosure;
Figure 1B illustrates a cross-section of an alternative arrangement of a substrate for a BGA according to an embodiment of the present disclosure;
Figure 1C illustrates an SEM image of a crack through a cross-section of the MAPBGA after stress testing;
Figure 2A illustrates toughness of four die attach materials at T0;
Figure 2B illustrates toughness of the four die attach materials at TC2000;
Figure 3A illustrates toughness of three solder mask materials at T0;

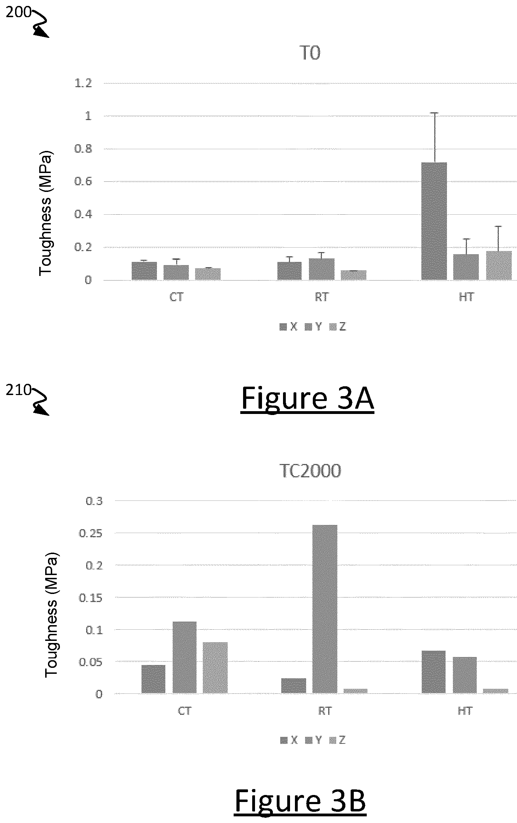

Figure 3A illustrates a toughness of the three solder mask materials at TC2000.

### DETAILED DESCRIPTION

The following detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or the following detailed description.

A new BGA material set is required to meet the automotive requirements and prevent stress failure commonly seen in current BGA and MAPBGA under Temperature Cycling (TC) stress testing at 2000 cycles (TC2000) and above. Temperature cycling is the process of cycling through two temperature extremes, typically at relatively high rates of change. It is an environmental stress test used in evaluating product reliability as well as in manufacturing to catch early-term, latent defects by inducing failure through thermal fatigue.

A conventional way of thinking would be to select a set of high toughness Die Attach (DA) and Solder Mask (SM) materials for a BGA device. However, this approach has been shown to not sufficiently solve the problem of overcoming stress failure at the higher demands required in the automotive industry. Careful selection of the materials that form the die attach and solder mask according to the present disclosure can improve resilience to stress failure.

The present disclosure identifies a unique stress index number to ensure selection of a correct material set (i.e. DA and SM) to pass prolonged temperature cycling (TC) stress cycles e.g. 3000 cycles (TC3000). The method used in determining which materials to use considers material properties of both the solder mask and die attach materials. These material properties include a coefficient of thermal expansion, Young's modulus, fracture toughness and shear adhesion strength. Material thickness is also considered.

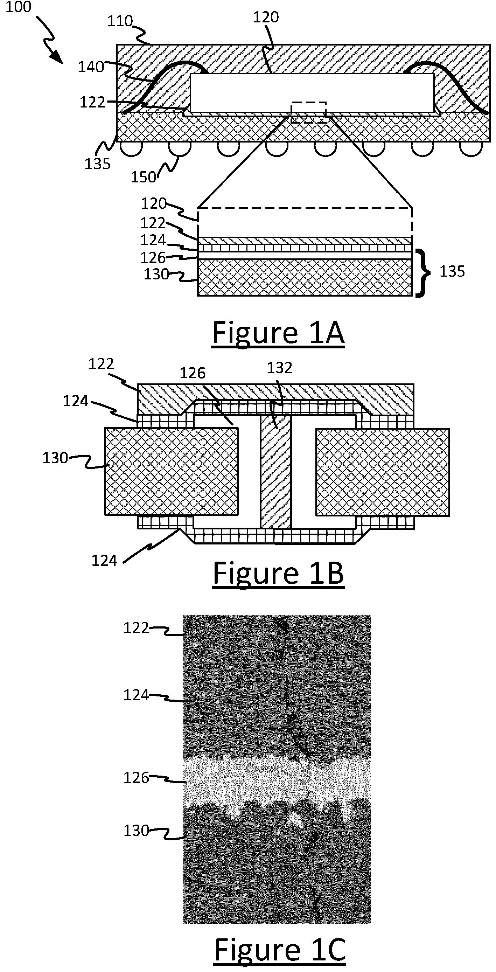

Figure 1A illustrates a cross-sectional view of a MAPBGA 100 according to an embodiment of the present disclosure. The MAPBGA comprises an Electronic Mold Compound (EMC) body 110, a die 120, die attach 122, a substrate 135, bond wires 140, and solder balls 150 in a typical MAPBGA arrangement. The die 120 is affixed to an upper surface of the substrate 135 with the die attach 122. The solder balls 150 are affixed to a lower surface of the substrate 135. The insert illustrates a close-up of the interface between the die 120 and the substrate 135 comprising sequential layers of die attach 122, and the substrate 135 which comprises a solder mask 124 layer on an upper surface of the substrate and forming an interface with the die attach 122, copper trace 126, and a core substrate material 130. The manufacturing process used to fabricate the MAPBGA can be chosen from any technique known in the art. A further solder mask layer can be provided between the lower surface of the substrate 135 and the solder balls 150.

Die attach 122 is used for attaching the die 120 to the substrate 135 providing a mechanical bond therebetween, it also establishes electrical connections and manages heat dissipation. Many die attach materials are commercially available, and have different material properties. Common materials used for die attachment include solder alloys, conductive adhesives, and eutectic compounds. These materials are chosen based on various factors such as their mechanical strength, thermal conductivity, electrical conductivity, and compatibility with the die and substrate materials. The specific choice of die attach material can significantly impact the performance and longevity of the electronic device. Die attach also contributes to the mechanical stability of the device. The die is fragile, and physical stresses whether from the assembly process, mechanical shock during handling or use, or thermal expansion and contraction can cause it to crack or delaminate from the package. A good die attach process creates a strong mechanical bond between the die and the package, helping to protect the die from these stresses.

Solder mask 124 is a thin layer of polymer that is applied to copper traces, or other metals such as Sn, for protection against oxidation and to prevent solder bridges from forming between closely spaced solder pads. Solder mask materials can include epoxy and dry film materials.

Suitable materials for the EMC body 110, die 120, bond wires 140, and solder balls 150 can be chosen according to standard procedures known to the skilled person, for example to meet desired design requirements. Variants in shape, size, design, etc. of the MAPBGA are also possible.

The illustrated BGA 100 of Figure 1A comprises a MAPBGA, however, the present disclosure can be applied to any suitable BGA having an interface between a die attach 122 and a solder mask material 124.

Figure 1B illustrates an alternative arrangement of a substrate for a BGA. The substrate comprising a core 130, a metal layer 126, and a via plug 132. The substrate comprising a solder mask 124 deposited on a top surface and a bottom surface of the substrate. A die attach 122 is deposited on the solder mask 124 of the top surface of the substrate.

Standard materials are used for the core 130, such as PCB or other suitable materials known in the art, and the metal 126 is also made of standard materials, such as copper or tin. The solder mask 124 is made from materials as described above in relation to Figure 1A. In some embodiments, the via plug 132 is made from a material which is the same as the solder mask 124. In other embodiments, the via plug 132 is made from a different material to the solder mask 124. The solder mask material 124 on an upper surface of the substrate that interfaces with the die and die attach material 122 may be the same or different material to the solder mask material 124 on a lower surface of the substrate.

The via plug 132 is defined as a plated through hole (PTH) in the BGA substrate core region 130 as shown in Figure 1B and serves as an electrical connection between solder mask 124 on the top surface and the solder mask 124 on the bottom surface of the substrate. The material used for the via plug can be the same solder mask material. However, a different material can be used for the via plug 132 instead, whose material property can have better resistance to heat and moisture, i.e. thermal stability. Using a different material can prevent the solder mask on the top surface of the substrate from becoming brittle.

In some embodiments, where the BGA comprises a substrate having a via plug that is a different material to the solder mask material, a Young's modulus of the via plug material is between 5 and 9 GPa at a temperature between -40 °C and 25 °C (room temperature).

In some examples, the via plug material has a first coefficient of thermal expansion of between 25 to 45 ppm/°C below a glass transition temperature. The via plug material has a second coefficient of thermal expansion between 90 and 120 ppm/°C above the glass transition temperature. The via plug material also has a water absorption rate of ≤ 0.3%.

The present disclosure describes the relationship between the die attach 122 and the solder mask 124. The material of the via plug 132 does not affect this relationship, whether or not it comprises the same material as the solder mask 124.

Figure 1C illustrates a scanning electron microscope image of an MAPBGA 100 exhibiting a crack resulting from stress testing that extends between the layers of the die attach 122, and substrate 135, the substrate comprising a solder mask 124 on an upper surface of the substrate and copper trace 126.

Material properties to consider of the die attach 122 and solder mask 124 when implementing the present disclosure include coefficient of thermal expansion (α), Young's modulus, fracture toughness, adhesion shear strength, and bond line thickness.

Coefficient of Thermal Expansion (CTE) is expressed as (m/m)/°C and describes how the size of an object changes with a change in temperature. Specifically, it measures the fractional change in size per degree change in temperature at a constant pressure, such that lower coefficients describe lower propensity for change in size.

According to the present disclosure, a difference between the CTE of the die attach material and solder mask material is a property that can be used to improve device strength to stress failure. In particular, this property in combination with a Young's modulus of the die attach material can be used to calculate a value that can help to identify whether the combination of materials will be suitable to withstand stress testing.

The Young's modulus (E) is a property of a material defined as the ratio of tensile stress (σ) to tensile strain (ε). Where stress is the amount of force applied per unit area (σ = F/A) and strain is extension per unit length (ε = dl/l). Young's modulus is measured in GPa.

To choose materials that have improved resilience to stress failure and cracking under test conditions, a unique stress index value describing a relationship between the properties of the materials of the die attach 122 and solder mask 124 has been determined as follows: ${Δ}_{CTE} \times Young ′ s {modulus}_{DA}$ Where Δ*_{CTE}* = | CTE_{DA} - CTE_{SM} | and the resulting value is measured in GPa/°C.

Experimental data has shown that materials for the die attach 122 and solder mask 124 according to this criteria with resulting values of 100 GPa/°C perform better than those with resulting values above 100 GPa/°C in stress tests as described below in more detail under experimental results. Optionally, resulting values of 70 GPa/°C and lower, more preferably 60 GPa/°C and lower, can be used in certain embodiments.

In some embodiments, fracture toughness is also taken into account in determining the materials to use in the BGA. Fracture toughness helps maintain reliability at high and low temperatures. Fracture toughness describes the resistance of brittle materials to the propagation of flaws under an applied stress, and it assumes that the longer the flaw, the lower is the stress needed to cause fracture. The ability of a flaw to cause fracture depends on the fracture toughness of the material. Whilst die attach 122 fracture toughness is also important, the relationship between the solder mask material and die attach material is more important than considering the fracture toughness of each of the materials in isolation.

In some embodiments, a fracture toughness of the solder mask 124 material is considered. A solder mask material preferably maintains its toughness over TC2000 cycles, which is required to meet automotive requirements.

There are two methods of determining a fracture toughness of a material. A first method measures toughness of the material and comprises nanoindentation which is a continuous measure of load versus nanometre displacement of a rigid indenter on a material surface that allows for the determination of material properties of elastic modulus and toughness. Nanoindentation measures toughness in MPa.m^{0.5}. A toughness of a solder mask material ≥ 2.3 MPa.m^{0.5} has been found to provide resilience to cracking under stress tests for solder mask materials that when matched with die attach materials satisfying have a stress index value of ≤ 100 GPa°C. This value should be exhibited for the solder mask material both as received and after ageing of the solder mask material (such as by temperature cycling for TC2000).

A fracture toughness of a material can be measured using standard tests such as by conventional stress-strain curve analysis. More specifically, the "toughness" of the material (also referred to as fracture toughness) is measured by the area under a stress/strain curve up to the point of fracture from a tensile test. Fracture toughness is measured in MPa.

If solder mask fracture toughness is high, for example meeting a criteria of ≥ 0.07 MPa , more preferably ≥ 0.10 MPa in certain conditions, the resulting BGA performs well in stress tests as described below in more detail under experimental results. This value should be exhibited for the solder mask material both as received and after ageing of the solder mask material (such as by temperature cycling for TC2000).

Combining values of Δ*_{CTE}* × *Young's modulus_{DA}* with solder mask fracture toughness can be used to further predict performance of BGAs against cracking. In combination with the resulting value of 100 GPa/°C and below, solder mask fracture toughness can be further used to predict whether a BGA will show good resistance to crack formation under stress testing. For example, performance of BGAs that are capable of withstanding stress tests of TC3000 and above is predicted when a solder mask material meets the following criteria of fracture toughness ≥ 0.07 MPa.

If solder mask fracture toughness is lower than this first threshold of 0.07 MPa, the Δ*_{CTE}* × *Young's modulus_{DA}* is predicted to be resistant to cracking under stress testing when combined with value of stress index values of ≤ 60 GPa/°C. Testing has shown that these materials having lower stiffness are still able to pass TC3000.

The solder mask toughness therefore helps to further predict device resistance to failure and cracking, where high solder mask toughness can be paired with a higher calculated stress index value and low solder mask toughness can be paired with a lower calculated stress index value in predicting BGA resilience to cracking. For example, if solder mask toughness is < 0.1 MPa, for example ≥ 0.07 MPa, the stress index value can be ≤ 60 GPa/°C and the resulting BGA is predicted to withstand stress testing without cracking. If solder mask toughness is ≥ 0.1 MPa, the stress index value can be ≤ 100 GPa/°C and still show resilience to cracking. These values should be exhibited for the solder mask material both as received and after ageing of the solder mask material (such as by temperature cycling for TC2000).

A further property to consider is an adhesion shear strength range between the die attach 122 and solder mask 124. Shear strength describes the force that the die attach 122 can withstand when stresses are applied parallel to the bond line. Die shear testing assesses a reliability of the die attach 122, testing adhesive strength between the die attach 122 and solder mask 124. In the test, a force is applied to a perpendicular direction to a die edge, parallel with the die attach 122.

Tests have shown that an adhesion shear strength of the die attach 122 and solder mask 124 in the range of ≥ 4 MPa is particularly advantageous, providing devices that perform well under testing.

Bond line thickness of the die attach 122 is a further consideration in BGA manufacture. Bond line thickness describes the thickness of the die attach layer between the die 120 and the substrate 135 of the BGA, for example after curing. The bond line thickness should be suitable to cope with stresses experienced by the material and ensure adhesion without allowing movement of the layers of the semiconductor device. In some embodiments, bond line thickness of the die attach 122 should be 50 µm or less. Particular advantages have been shown with a thickness of 25 µm. Thinner bond lines break at higher strengths compared to thicker bond lines.

The above material selection is suitable for BGAs, in particular MAPBGA and Wire Bond (WB) MAPBGA. Existing techniques for fabricating BGA can be used once the material set has been chosen according to the above criteria.

### Experimental results

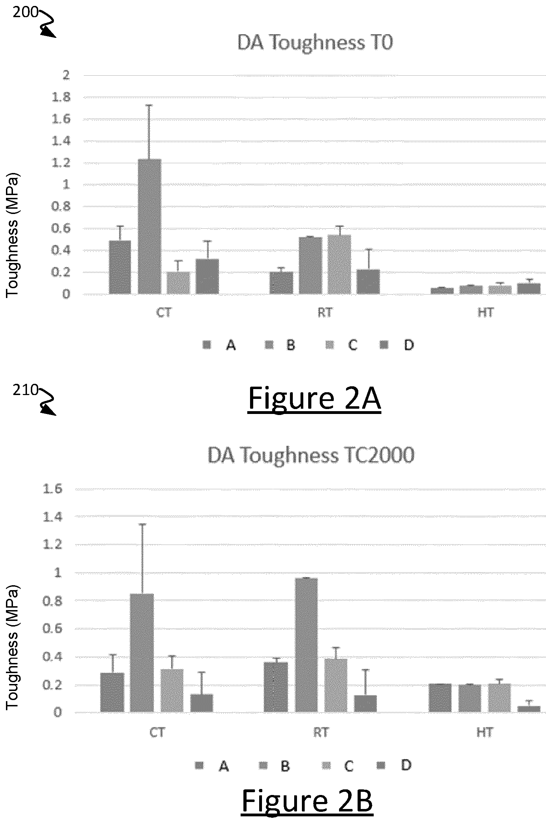

Figure 2A illustrates fracture toughness of different die attach materials. The materials were tested according to a stress-strain curve test and tested at time zero (T0) whereby the materials are tested as received. Toughness of four die attach adhesive materials A, B, C and D were measured at three different temperatures cold temperature (CT) for example -40°C, room temperature (RT) and high temperature (HT) for example 150°C. CT testing is important for understanding failure since materials become brittle at these temperatures and more likely to fracture.

At T0, for CT, material B was the toughest material, followed by A, D and finally C, indicating that die attach material BA has the highest toughness. At RT, C is the toughest material, and at HT, toughness is significantly reduced with material D shown to be the toughest material.

Figure 2B illustrates fracture toughness of the same die attach materials used in Figure 1A using the same testing methods and temperature ranges tested at TC2000. The same result was found for T0 for the toughness of materials measured at TC2000, where die attach material B showed highest toughness at CT and RT. At HT, materials A, C and D exhibited similar toughness.

According to existing thinking, die attach material B therefore would be seen as a good candidate for choosing as a die attach material in a BGA device due to its high toughness. However, further tests show that when combining the die attach materials with a solder mask material in a BGA device, material B had the worst results when subjected to TC stress testing.

Further test data is illustrated below in Table 1 comprising experimental data from conducting temperature cycling (TC) stress tests using different die attach (DA) materials A to D discussed above in relation to Figures 2A and 2B and solder mask (SM) materials X, Y and Z.

**Table 1. Experimental data of stress testing with four different die attach materials and three different solder mask materials.**

| DA-SM interface | \|Δ*_{CTE}*\| at -40°C | Young's Modulus of DA at TC2000 and at CT (GPa) | \|Δ*_{CTE}*\| × *Ym_{DA}* (GPa/°C) | TC results |
|---|---|---|---|---|
| DA-B/SM-Y | 106 | 1.5 | 159 | 1st fail at TC3500 |
| DA-B/SM-X | 89 | 1.5 | 133.5 | 1st fail at TC2000 |
| DA-C/SM-Y | 11 | 6 | 66 | 1st fail at TC3500 |
| DA-A/SM-Z | 12 | 5 | 60 | 1st fail at TC3000 |
| DA-A/SM-X | 12 | 5 | 60 | 1st fail at TC3000 |
| DA-D/SM-Y | 11 | 4.5 | 49.5 | 1st fail at TC3500 |
| DA-D/SM-X | -6 | 4.5 | 27 | 1st fail at TC3000 |
| DA-A/SM-Y | 5 | 5 | 25 | Passing TC4000 |

The DA-SM interface refers to the die attach (DA) and solder mask (SM) materials used. Δ*_{CTE}* between the DA and SM materials is measured for each combination of materials at -40°C (i.e. CT which is the farthest away temperature point from the cure temperature (at zero stress) for DA. It is known the crack initiated at this temperature. A Young's modulus of the die attach material is measured at -40°C (CT) after 2000 cycles (TC2000) is calculated. Results are ordered according to descending stress index value of Δ*_{CTE}* × *Ym_{DA}* (GPa/°C).

The best performing combination of materials in Table 1 (having die attach material A and solder mask material Y) passed stress testing at TC4000 and has a calculated value Δ*_{CTE}* × *Ym_{DA}* of 25 GPa/°C. The worst performing combination of materials (die attach material B with solder mask material X) failed stress testing at the earliest point compared to the other combinations of materials in the study at TC2000, having a Δ*_{CTE}* × *Ym_{DA}* value of 133.5 GPa/°C.

For automotive applications, the requirements are that the device should not fail below TC2200. Material combinations having a calculated value Δ*_{CTE}* × *Ym_{DA}* of < 100 GPa/°C in Table 1 each begin to fail at TC3000 or higher. The calculated value of Δ*_{CTE}* × *Ym_{DA}* therefore provides a good indication of whether the materials will be suitable for electric vehicle applications to a first approximation. A combination of DA-B/SM-Y has a stress index value of 159 GPa°C indicating that in some cases, having a stress index value of > 100 GPa°C can also prove to be resilient to cracking under stress testing.

A further factor to consider is a fracture toughness (also referred to as "toughness") of the solder material. Figure 3A illustrates toughness of three solder mask materials (X, Y, Z) at T0. Figure 3B illustrates a toughness of the three solder mask materials (X, Y, Z) at TC2000. The solder mask materials correlate with those used above in Table 1. A fracture toughness value is measured from a specially prepared specimen of the solder mask material with free-standing-solder-mask film being subjected to conventional tensile stress test not described herein. The fracture toughness of the solder mask material is preferably ≥ 0.10 MPa from both an as-received and an aged sample, aged after TC2000 (-55°C to 150°C) at CT (-50°C). The sample used for the testing has width of 10 mm, thickness of 0.04 mm, and length of 20 mm.

It is advantageous for the solder mask 124 material to maintain its toughness over TC2000 cycles, which is required to meet automotive requirements. Fracture toughness of this value and above help maintain reliability at high and low temperatures.

Between the materials X, Y and Z shown in Table 1 above, X has a greater fracture toughness at high temperature at T0 whilst Y has the lowest fracture toughness at high temperature at T0. At CT, cold temperature X exhibits the greatest toughness, followed by Y and then Z. At room temperature, Y is the toughest followed by X and then Z.

At TC2000 whereby the toughness of the materials is measured after stress testing, the results are different to those at T0. Solder mask material Y shows the greatest toughness at cold and room temperature. Material X is the least tough at cold and room temperature. Maintaining toughness of the solder mask material after TC2000 is an important factor in choosing a solder mask material that will withstand stress testing and resist cracking.

The die attach materials all show improved results in combination with Y which has a fracture toughness greater than X and Z at cold and room temperature after TC2000. At both cold and room temperature solder mask material Y has a measured toughness of greater than 0.10 MPa. In the above Table 1, all of the die attach materials (A to D) that are combined with solder mask material Y perform well, failing first at TC3500 or above. This indicates that solder mask toughness can also be useful in predicting resilience of a BGA to cracking.

Studies have shown that a hardness of the solder mask 124 should be ≥ 2.0 MPa.m^{0.5}, for example ≥ 2.3 MPa.m^{0.5}. The 2.3 MPa.m^{0.5} hardness value is extracted from data obtained from a nano indentation test on as-received solder mask material sample for a BGA unit at room temperature.

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

## Claims

1. A semiconductor device having a Ball Grid Array, BGA, the device comprising:
a substrate comprising a solder mask material, the substrate having an upper and a lower surface;
a die;
a die attach material for affixing the die to the upper surface of the substrate; and
a plurality of solder balls arranged on the lower surface of the substrate;
wherein the die attach material has a first coefficient of thermal expansion and the solder mask material has a second coefficient of thermal expansion;
wherein a difference between the first and second coefficients of thermal expansion multiplied by a Young's modulus of the die attach material is ≤ 100 GPa/°C.

2. The semiconductor device of claim 1, wherein the solder mask material is formed on the upper surface of the substrate and forms an interface with the die attach material.

3. The semiconductor device of claim 1 or claim 2, wherein the solder mask material is formed on the lower surface of the substrate.

4. The semiconductor device of any preceding claim, wherein a fracture toughness of the solder mask material is ≥ 0.10 MPa.

5. The semiconductor device of any of claims 1 to 3, wherein a fracture toughness of the solder mask material is < 0.10 MPa and ≥ 0.07 MPa.

6. The semiconductor device of claim 5, wherein the difference between the first and second coefficients of thermal expansion multiplied by a Young's modulus of the die attach material is ≤ 60 GPa/°C.

7. The semiconductor device of any preceding claim, wherein a toughness of the solder mask material is ≥ 2.0 MPa.m^{0.5}; optionally wherein a toughness of the solder mask material is ≥ 2.3 MPa.m^{0.5}.

8. The semiconductor device of any preceding claim, wherein a shear adhesion strength range between the die attach and solder mask materials is ≥ 4 MPa.

9. The semiconductor device of any preceding claim, wherein a bond line thickness of the die attach material is ≤ 50 µm.

10. The semiconductor device of claim 9, wherein the bond line thickness of the die attach material is ≥ 25 µm.

11. The semiconductor device of any preceding claim, wherein the substrate comprises a via plug that is a different material to the solder mask material.

12. The semiconductor device of claim 11, wherein a Young's modulus of the via plug material is between 5 and 9 GPa.

13. The semiconductor device of claim 11 or claim 12, wherein the via plug material has a first coefficient of thermal expansion of between 25 to 45 ppm/°C below a glass transition temperature; and wherein the via plug material has a second coefficient of thermal expansion between 90 and 120 ppm/°C above the glass transition temperature.

14. The semiconductor device of any of claims 11 to 13, wherein the via plug material has a water absorption rate of ≤ 0.3%.

15. The semiconductor device of any preceding claim, wherein the BGA is a Mold Array Process Ball Grid Array, MAPBGA.

## Amended claims

### Amended claims in accordance with Rule 137(2) EPC.

1. A semiconductor device having a Ball Grid Array, BGA, the device comprising:
a substrate comprising a solder mask material, the substrate having an upper and a lower surface;
a die;
a die attach material for affixing the die to the upper surface of the substrate; and
a plurality of solder balls arranged on the lower surface of the substrate;
wherein the die attach material has a first coefficient of thermal expansion and the solder mask material has a second coefficient of thermal expansion;
wherein an absolute value of a difference between the first and second coefficients of thermal expansion, multiplied by a Young's modulus of the die attach material, is ≤ 100 GPa/°C;
wherein the substrate comprises a via plug that is a different material to the solder mask material; and
wherein the via plug material has a first coefficient of thermal expansion of between 25 to 45 ppm/°C below a glass transition temperature; and wherein the via plug material has a second coefficient of thermal expansion between 90 and 120 ppm/°C above the glass transition temperature.

2. The semiconductor device of claim 1, wherein the solder mask material is formed on the upper surface of the substrate and forms an interface with the die attach material.

3. The semiconductor device of claim 1 or claim 2, wherein the solder mask material is formed on the lower surface of the substrate.

4. The semiconductor device of any preceding claim, wherein a fracture toughness of the solder mask material is ≥ 0.10 MPa.m^0.5.

5. The semiconductor device of any of claims 1 to 3, wherein a fracture toughness of the solder mask material is < 0.10 MPa.m^0.5 and ≥ 0.07 MPa.m^0.5.

6. The semiconductor device of claim 5, wherein the difference between the first and second coefficients of thermal expansion multiplied by a Young's modulus of the die attach material is ≤ 60 GPa/°C.

7. The semiconductor device of any preceding claim, wherein a toughness of the solder mask material is ≥ 2.0 MPa.m^{0.5}; optionally wherein a toughness of the solder mask material is ≥ 2.3 MPa.m^{0.5}.

8. The semiconductor device of any preceding claim, wherein a shear adhesion strength range between the die attach and solder mask materials is ≥ 4 MPa.

9. The semiconductor device of any preceding claim, wherein a bond line thickness of the die attach material is ≤ 50 µm.

10. The semiconductor device of claim 9, wherein the bond line thickness of the die attach material is ≥ 25 µm.

11. The semiconductor device of claim 11, wherein a Young's modulus of the via plug material is between 5 and 9 GPa.

12. The semiconductor device of any preceding claim, wherein the via plug material has a water absorption rate of ≤ 0.3%.

13. The semiconductor device of any preceding claim, wherein the BGA is a Mold Array Process Ball Grid Array, MAPBGA.
